Europäisches Patentamt

European Patent Office

Office européen des brevets

(11) Publication number: **0 098 406**
A1

# (12) EUROPEAN PATENT APPLICATION

(21) Application number: 83105710.4

(22) Date of filing: 10.06.83

(51) Int. Cl.³: **C 30 B 33/00**, C 30 B 29/06, C 03 B 32/00, H 01 L 21/322

(30) Priority: 06.07.82 US 395195
06.07.82 US 395194

(43) Date of publication of application: 18.01.84
Bulletin 84/3

(84) Designated Contracting States: DE FR GB NL

(71) Applicant: TEXAS INSTRUMENTS INCORPORATED, 13500 North Central Expressway, Dallas Texas 75265 (US)

(72) Inventor: Pinizotto, Russell F., 1902 Clover Trail, Richardson Texas 75081 (US)
Inventor: Schaake, Herbert F., 1517 Angelina Bend, Denton Texas 76201 (US)
Inventor: Massey, Robert G., 318 Chisholm Trail, Sherman Texas 75090 (US)
Inventor: Heidt, Donald W., 49 Tate Circle Route 1, Sherman Texas 75090 (US)

(74) Representative: Leiser, Gottfried, Dipl.-Ing. et al, Patentanwälte Prinz, Bunke & Partner Ernsberger Strasse 19, D-8000 München 60 (DE)

(54) Ramped nucleation of solid state phase changes.

(57) For faster processing of any solid-state phase change which is rate-limited by nucleation, the material temperature is steadily and gradually increased from a first temperature, where nucleation but not significant growth occurs, up to a second higher temperature, where rapid growth occurs. Since most of the nuclei survive to grow at the higher temperature, completed growth is far more rapidly attained than with prior art annealing processes, where a constant nucleation temperature and a constant (higher) growth temperature are used. In a sample embodiment, this is applied to oxygen precipitation in silicon.

RAMPED NUCLEATION OF SOLID STATE PHASE CHANGES

BACKGROUND OF THE INVENTION

The present invention relates to a method for rapidly achieving phase transformations in solids.

The present invention is applicable to increase the speed of any process in which a phase transformation in solids is rate-limited by nucleation. Important examples of such processes are in oxygen precipitation in silicon and in annealing of glass ceramics. However, this invention is applicable to a great variety of other processes, since it has general applicability and is not limited by the pecular characteristics of the principal embodiments discussed below.

Oxygen precipitation in Czochralski-grown silicon is currently used for intrinsic gettering of heavy metals and other impurities. The oxygen is present in as-grown material at concentrations on the order of $10^{18}$ per cubic centimeter, because the quartz liner used to hold the molten silicon is partially dissolved during crystal growth. The amount of oxygen which is thus incorporated into the as-grown crystal is above the solubility limit for oxygen in silicon at normal integrated circuit device processing temperatures. During processing of integrated circuit devices, the supersaturated concentration of interstitial oxygen reacts with silicon to form silicon dioxide. The particles of silicon dioxide which are formed by this process generate dislocations, which serve to trap mobile impurities.

The process whereby interstitial oxygen reacts to form silicon dioxide particles takes place in two steps: nucleation and growth. During nucleation, the number of precipitate particles (i.e. $SiO_2$) is increasing, and the total amount of silicon dioxide per unit volume is also increasing. During the growth stage, the number of precipitation locations remains constant, while the volume concentration of silicon dioxide is still increasing. A third stage (coarsening) can also occur, wherein the number of particles (precipitate locations) is decreasing, while the volume concentration of silicon dioxide remains constant and equal to the thermal equilibrium concentration. In many processes, such as solid state phase transformations in metals, nucleation and growth occur simultaneously. However, for oxygen in silicon, the nucleation and growth can be separated into separate temperature regimes and hence independently controlled. There exists a large body of literature dealing with these phenomena. For example, see U.S. Patent No. 4,314,595 to Yamamoto. All of these citations are hereby incorporated by reference.

In prior art processes, the wafer is held at a first temperature, such as 600°C, at which nucleation of silicon dioxide precipitates occurs. After time enough for substantial nucleation to occur, the wafer is heated to a second temperature, where rapid growth can occur, such as 1000°C. However, in such a two step process, a large fraction of the nuclei initially generated will dissolve when the wafer is heated to the higher temperature. (The surface-to-volume ratio becomes high for very small particles, and thus the interface energy dominates for small particles, which is why particles below a certain (temperature-dependent) critical size tend to dissolve.) Thus, growth at the higher temperature actually occurs on a relatively small number of particles, and complete growth to equilibrium is therefore slow. Typically, a total annealing time of eight or ten hours may be required in such a prior art process.

A further effect of the long growth time required by the precipitation methods of the prior art is that large crystallites of silicon dioxide will be grown from the relatively few surviving nuclei. However, excessively large precipitated particles are believed not to be optimal, since the localized lattice distortion imposed is greater than that required to trap impurities, and since the average density of impurity traps (lattice distortion sites) is lower.

Another area of art where two-plateau annealing has conventionally been used is in glass-ceramic materials.

In such materials, nucleation is typically performed at a first holding temperature, and the material is then heated, as fast is permitted by thermal shock, to a second temperature at which growth on the surviving nuclei occurs. However, a large fraction of the nuclei formed at the nucleation temperature will have an excessively smaller size at the higher (growth) temperature, and will therefore be redissolved. Thus, growth takes place on a smaller number of nuclei than was originally formed. This is undesirable in this art, since it is highly desirable that the crystals formed in glass-ceramic processing be small and uniform in size.

In the prior art of glass-ceramic processing, the necessary large number of nuclei at the growth temperature is often achieved adding a high concentration (e.g. 5%) of a nucleating agent, such as titanium dioxide, zirconium dioxide, phosphorus pentoxide, heavy metals, or fluorides. However, such large concentrations of a nucleating agent may themselves be deleterious to the desired mechanical properties of the resulting material.

Thus it is an object of the present invention to provide a method for copiously nucleated growth of a second phase in solid state phase changes, without adding large amounts of heterogeneous nucleating agents.

It is a further object of the present invention to provide a general method for precipitating supersaturated impurities in crystalline semiconductors.

It is a further object of the present invention to provide a method for rapidly nucleating and growing a second phase in a solid state phase change process.

- 4 -

0098406

Thus, it is an object of the present invention to provide a faster process for precipitating dissolved oxygen in silicon to achieve equilibrium.

Thus, it is an object of the present invention to provide a method for precipitating silicon dioxide from solid silicon at many sites.

It is a further object of the present invention to provide silicon wafers, having silicon dixoide particles of average size less than 50 nm at many sites.

- 5 -                                    0098406

## SUMMARY OF THE INVENTION

The present invention modifies the temperature treatment used to precipitate silicon dioxide in Czochralski-grown silicon. In place of a two-plateau temperature cycle, a steadily increasing temperature "ramping" step is used to raise the temperature of the wafer from the nucleation range up into the growth range. The result of this is that most of the nuclei which are precipitated at the lower temperature gradually grow as the temperature is raised, so that a great many growth centers survive into the growth temperature range. By contrast, in the prior art, most of the precipitated nuclei are dissolved when the temperature is raised into the growth range.

According to the present invention, there is provided: a method for rapidly inducing a solid state material to change from a first phase to a second phase, comprising the steps of: heating said material to a first temperature at which rapid nucleation of said second phase occurs within the matrix of said first phase; ramping the temperature of said material steadily up to a second temperature, where rapid growth of said second phase occurs, said ramping step being performed gradually and continuously; whereby particles of said second phase which are nucleated at and near said first temperature are continuously grown during said ramping step, to provide large particles of said second phase.

BRIEF DESCRIPTION OF THE DRAWINGS

The present invention will be described with reference to the accompanying drawings wherein:

Figure 1 shows the dependence of various free energy terms on particle radius;

Figure 2 shows the temperature dependence of the critical particle radius (the radius above which particles survive and grow);

Figure 3 shows the variation of neucleation rate with temperature;

Figure 4 shows the size distribution of particles newly formed;

Figure 5 shows the change in particle size distribution with time, in the process of the present invention;

Figure 6 shows the effect of discontinuous change in critical particle size;

Figure 7 shows particle size distributions resulting from the techniques of the prior art;

Figure 8 compares the temperature (and critical radius) control taught by the present invention with that of the prior art;

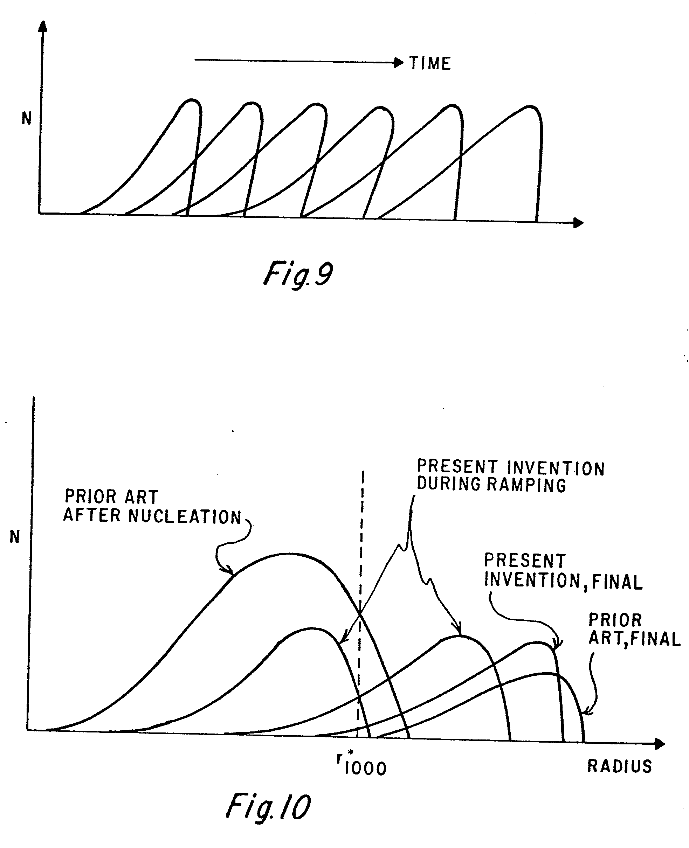

Figure 9 shows progressive particle size distributions during the process of the present invention;

Figure 10 compares particle size distributions achieved by the present invention and in the prior art.

## DESCRIPTION OF THE PREFERRED EMBODIMENTS

For homogeneous nucleation, the phase transformation is driven by a reduction in free energy given by $\Delta G = \Delta G_V + \sigma + E$, where $\Delta G$ is the total energy change, $\Delta G_V$ is the change in volume free energy, usually $< 0$ for the reaction to occur, $\sigma$ is the interfacial energy between the matrix, $\alpha$, and $\beta$ and $E$ is a strain energy term. $\sigma$ and $E$ are $> 0$. For simplicity, ignore $E$ which can be treated as a change in $\Delta G_V$. Then for a spherical particle:

$$\Delta G = \frac{4}{3} \pi r^3 \Delta G_V + 4 \pi r^2 \sigma$$

but $\Delta G_V = \Delta E_V \left( \dfrac{T_E - T}{T} \right)$

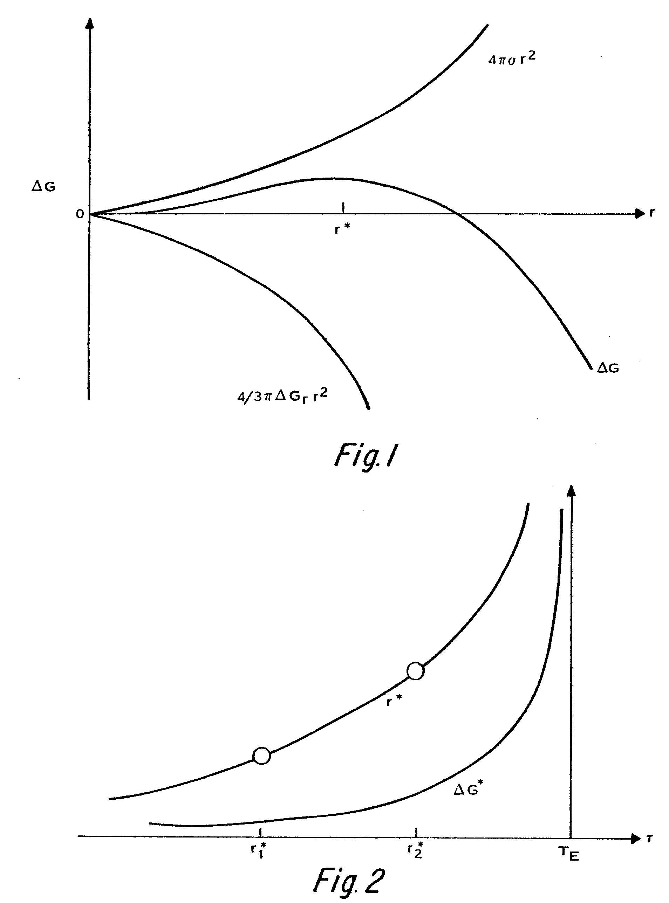

where $\Delta E_V$ = enthalpy volumetric change, $T$ = temperature and $T_E$ = transformation temperature, which in this case is the temperature at which all the oxygen in the crystal is in solution, which is close to the melting point of the silicon. Since $\Delta E_V < 0$ and $\sigma > 0$, there is some $r$ where $\Delta G = 0$. If one plots the variables of interest, as in Fig. 1, $r^*$ is the radius above which $\Delta G$ monotonically decreases with increasing $r$. It is the $r$ such that $\dfrac{d\Delta G}{dr} = 0$. One finds that:

$$r^* = \frac{-2\sigma}{\Delta G_V} = \frac{-2\sigma T_E}{\Delta E_V \, \Delta T}$$

the value of $\Delta G$ at $r^* = (\Delta G^*)$ is

$$\Delta G^* = \frac{16\pi\sigma^3}{3\Delta G_V^2} = \frac{16}{3} \pi \frac{\sigma^3}{\Delta E_V^2 \Delta T^2} T_E^2$$

hence both $r^*$ and $G^*$ are functions, as sketched in Fig. 2. The nucleation rate, $J$, is proportional to the number of nuclei that are stable and the ability of atoms to reach this nucleus. So

$$J \, \alpha \, \exp(-\Delta G^*/kt) \, \exp(-E_D/kt)$$

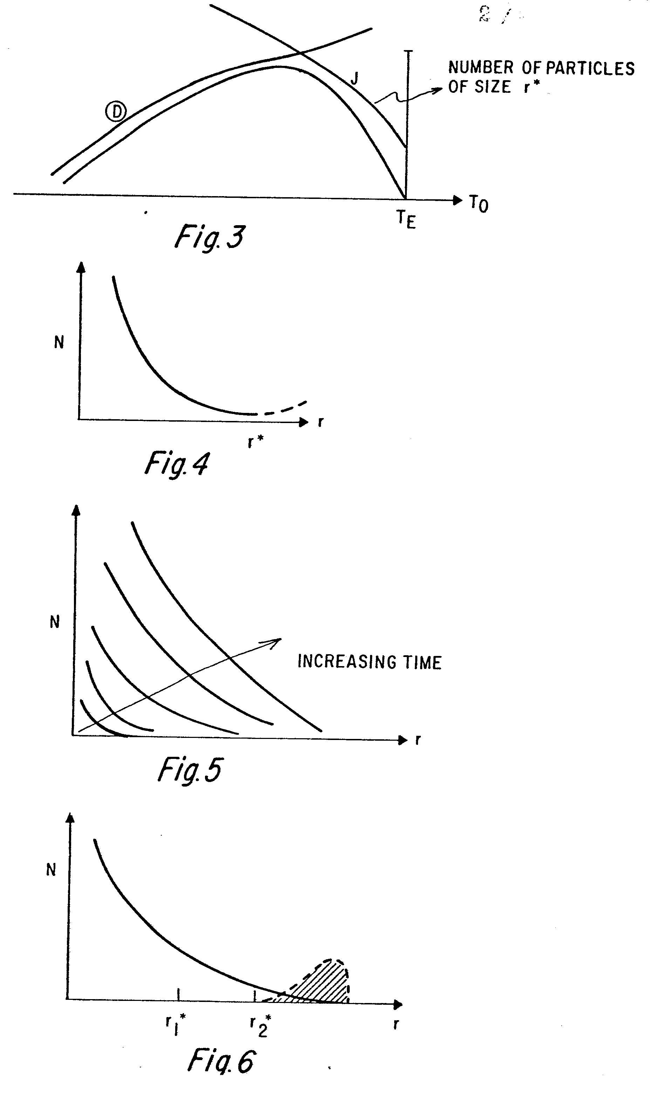

where $E_D$ is the activation energy for diffusion. The nucleation rate thus varies with temperature as shown in Fig. 3 because the nucleation rate is constantly increasing while diffusion is decreasing as T is lowered.

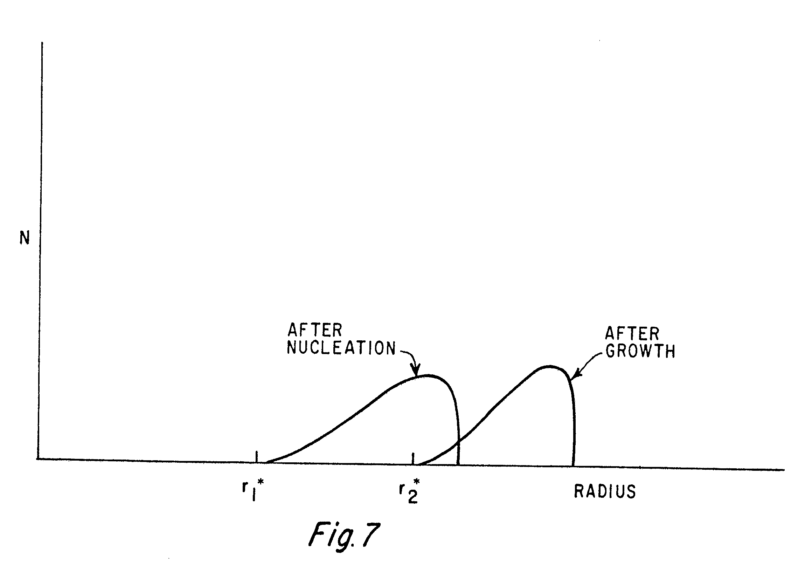

The basic principles of the new ramping technique may now be discussed and compared to isothermal processing. During an isothermal process for nucleation, say at 600-750°C, embryos, i.e. particles with r<r*, are constantly forming. Since the distribution is proportional to $\Delta G$ in an Arrhenius relationship, $N(r) \alpha \exp(-\Delta G/kt)$ as shown in Fig. 4. For $r > r*$, the particles can grow limited only by kinetics. The particle size distribution as a function of time at constant temperature can be plotted as shown in Fig. 5. Thus after any given time, there is basically an exponentially decaying with size distribution of particles. This is the whole purpose of the nucleation anneal. The effect of the growth step is to cause the previously formed particles to grow. Not all the $\beta$ -embryos grow at high temperature. Only those with r >r* at the higher temperature survive. For example, assume that after a nucleation anneal at 700°C, the size distribution is as shown in Fig. 6. The critical size at 700°C is indicated by $r_1*$. The critical size at the growth temperature, e.g. 1000°C, is shown in Fig. 7 by $r_2*$. (Refer also to Fig. 2.) Only those particles larger than $r_2*$ will grow; the others will shrink. Nucleation of new particles at the growth temperature is small; it can be neglected. The particle size distribution after growth is shown by the rightmost curve in Fig. 7. Classical isothermal nucleation is thus concerned with growing embryos at the low temperature so that some small fraction of them survive the high temperature. These explanations have been published by Kishino in J. Phys. Soc. Japan, 49 (1980) Suppl. A, pp. 49-56. The actual particles of interest may be in a somewhat different distribution. The ramping technique of the present invention eliminates the discontinuity in the value of r* by smoothly varying the temperature and therefore r* as well. The sample is placed in a furnace at a very low temperature, e.g. 425°C

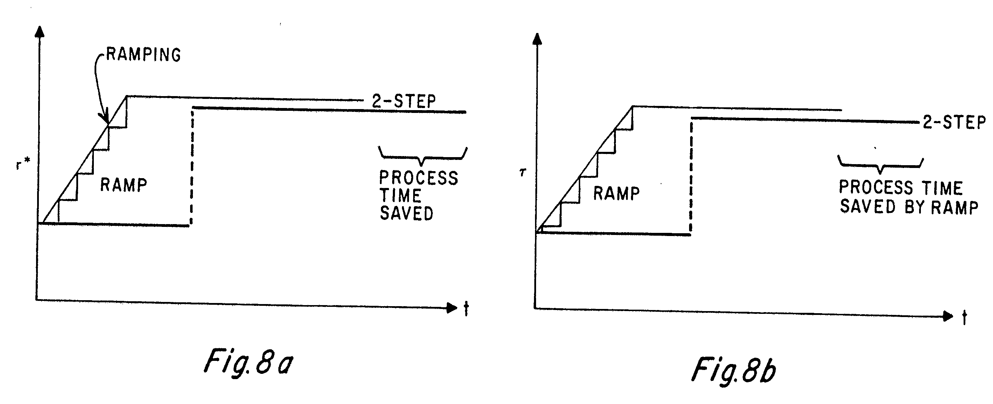

or less. The anneal temperature is thenincreased gradually to the growth temperature, e.g. 1000ºC. A first embodiment of the invention has been demonstrated using many 25ºC step changes, to avoid the need for programmable temperature controllers ona readily available laboratory furnace. The behavior of r* and T with time are sketched in Fig. 8. The particle size distribution also varies smoothly with respect to time when the temperature is ramped. The change in r* per step is relatively small, so the number of particles which do not grow, but dissolve is small as well. The differences in the size distribution due to ramping compared to isothermal annealing can be quite dramatic, as shown in Figure 10.

Some sample x-ray topography results, obtained from comparative samples showing the result of the present invention, are shown in Table 1.

### Average X-Ray Intensity

| Time at 1000ºC (hrs) | Temperature at Start of Nucleation Ramping | | | | |
| | 425 | 500 | 600 | 700 | Comments |
|---|---|---|---|---|---|
| 0 | 1975 | 1975 | 1975 | 1950 | "Background" |
| 2 | 2800 | 2200 | 2050 | 1950 | ppt in 425&500 samples |
| 8 | 6800 | 5400 | 2600 | 2200 | ppt in all |
| 24 | 9300 | 8900 | 6800 | 4500 | ppt in all |

Note that higher numerical values here indicate a greater concentration of silicon dioxide precipitates.

In an alternative embodiment of the invention, the ramping is not performed at a constant rate. That is, additional economies of time are achieved by using a faster average ramping rate over the temperature range where neucleation has mostly been completed, and using the slowest ramping rate in the low-temperature range where neucleation is still critical. That is, in a sample of this embodiment of the invention, the starting temperature for the ramp is 400°C. The temperature is initially increased at a rate of 80°C per hour, and the rate of temperature increase is itself steadily increased, until, at 1000°C where the ramping step is terminated, the rate of increase is 200°C per hour. That is, a second-order curve is used to control the ramping. Of course, other nonlinear curves may be used. This modification provides slightly greater economies of time than the principal embodiment previously discussed.

Thus, the present invention provides the key advantage of shorter annealing times required to precipitate dissolved oxygen in silicon and silicon dioxide.

The present invention also provides the advantage that, after precipitation of dissolved oxygen and silicon dioxide according to the present invention, the density of silicon dioxide particles in the silicon is higher than with prior art methods.

It will be apparent to those skilled in the art that the present invention provides a basic innovation in silicon processing which can be used in a great variety of integrated circuit fabrication processes and which can be widely modified. The present invention is not limited except as claimed below.

The present invention advantageously provides silicon integrated circuit material incorporating silicon dioxide particles of small and uniform size.

The present invention provides the further advantage of a rapid process for oxygen precipitation in silicon.

Thus, the present invention is applicable not only to such processes as precipitation of oxygen and silicon, but is also applicable to other precipitation processes where the nucleation is a rate-limiting step. For example, it is also applicable to precipitation of other dissolved impurities in silicon or other semiconductors. It is also applicable to growth of crystalline domains in a glassy matrix, or to other solid state phase change processes.

Thus the present invention provides the advantage of providing a method for copiously nucleated growth of a second phase in solid state phase changes, without adding large amounts of heterogenous nucleating agents.

The present invention further provides the advantage of providing a general method for precipitating supersaturated impurities in crystalline semiconductors.

The present invention further provides the advantage of providing a method for rapidly nucleating and growing a second phase in a solid state phase change process.

It will be obvious to those skilled in the art that the present invention provides a fundamental innovation in materials processing. It is applicable to a wide variety of processes, whether heterogenously or homogeneously nucleated, as long as the process is thermally activated.

Thus, the scope of the present invention is not limited except as in the appended claims.

CLAIMS

<u>WHAT WE CLAIM IS</u>:


1.   A method for rapidly inducing a solid state material to change from a first phase to a second phase, comprising the steps of:

heating said material to a first temperature at which rapid nucleation of said second phase occurs within the matrix of said first phase;

ramping the temperature of said material steadily up to a second temperature, where rapid growth of said second phase occurs, said ramping step being performed gradually and continuously;

whereby particles of said second phase which are nucleated at and near said first temperature are continuously grown during said ramping step, to provide large particles of said second phase.


2.   The method of Claim 1, wherein:

said ramping step is performed more slowly at temperatures near said first temperature than at temperatures near said second temperature.

0098406

CLAIMS
WHAT WE CLAIM IS:

3.   A method for rapidly growing silicon dioxide particles of uniform size in silicon including dissolved oxygen, comprising the steps of:

heating said silicon to a first temperature at which rapid nucleation of silicon dioxide particles occurs in said silicon;

ramping the temperature of said silicon steadily up to a second temperature, where rapid growth of silicon dioxide particles occurs, said ramping step being performed over a total time of at least one hour; and then

annealing said silicon at said second temperature.

4.   The method of Claim 1, wherein said first temperature is less than $600^{\circ}C$.

5.   The method of Claim 1, wherein said second temperature is at least $900^{\circ}C$.

6.   The method of Claim 2, wherein said second temperature is at least $900^{\circ}C$.

7.   The method of Claim 1, wherein said ramping step is performed in a repeated sequence of small temperature increments.

8.   The method of Claim 1, wherein said ramping step is performed at a constant rate of increase of temperature.

9.   The method of Claim 1, wherein said ramping step is performed at a rate of temperature increase which is no where greater than $200^{\circ}C$ per hour.

0098406

10. The method of Claim 1, wherein said ramping step is performed at a sufficiently low average rate of temperature change, intermediate between said first temperature and said second temperature, that nuclei of silicon dioxide formed in said silicon continue to grow without being redissolved during said ramping stage.

11. The method of Claim 1, wherein said ramping step is performed more slowly at temperatures near said first temperature than at temperatures near said second temperature.

Fig. 1

Fig. 2

Fig. 3

NUMBER OF PARTICLES OF SIZE $r^*$

0098406

Fig. 4

INCREASING TIME

Fig. 5

Fig. 6

**Fig. 7**

*Fig. 8a*

*Fig. 8b*

4 / 5

0098406

5 / 5

0098406

TIME

N

*Fig.9*

PRESENT INVENTION
DURING RAMPING

PRIOR ART
AFTER NUCLEATION

PRESENT
INVENTION, FINAL

PRIOR
ART, FINAL

N

$r^*_{1000}$

RADIUS

*Fig.10*

European Patent
Office

**EUROPEAN SEARCH REPORT**

0098406

Application number

EP 83 10 5710

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-3 977 857 (D. MATTOX) <br><br> * Claim 1; column 4, lines 24-58 * <br><br> --- | 1,4,8, 9 | C 30 B 33/00 <br> C 30 B 29/06 <br> C 03 B 32/00 <br> H 01 L 21/322 |
| E | EP-A-0 060 676 (FUJITSU) <br><br> * Claim 1; figure 1 * <br><br> --- | 1,3,4, 5,6,8, 9,10 | |
| X | FR-A-2 125 587 (PILKINGTON BROTHERS) <br> * Pages 4,5 * <br><br> ----- | 1,7 | |

**TECHNICAL FIELDS SEARCHED (Int. Cl. ³)**

C 30 B 33/00
C 30 B 29/06
C 03 B 32/00
H 01 L 21/322

The present search report has been drawn up for all claims

| Place of search <br> THE HAGUE | Date of completion of the search <br> 14-10-1983 | Examiner <br> BRACKE P.P.J.L. |
|---|---|---|